# EUROPEAN PATENT APPLICATION

(11) **EP 3 263 353 A1**
(43) Date of publication of application: **03.01.2018**
(21) Application number: 16755107.6
(22) Date of filing: 26.01.2016
(51) Int. Cl.: B41N 1/12, B41C 1/05, B41F 5/00, G03F 7/00

(54) **FLEXOGRAPHIC PRINTING PLATE AND METHOD FOR MANUFACTURING FLEXOGRAPHIC PRINTING PLATE**

(30) Priority: 27.02.2015 JP 2015038795
(71) Applicant: FUJIFILM Corporation, Tokyo 106-8620 (JP)
(72) Inventor: MORIKAWA Seiichiro, Haibara-gun Shizuoka 421-0396 (JP)
(74) Representative: Hoffmann Eitle
(86) International application number: PCT/JP2016/052113
(87) International publication number: WO 2016/136357

(57) **Abstract**

Provided are a flexo printing plate, which makes it possible to print an image without unevenness by inhibiting bouncing that occurs in a case where the distal end of an image portion of a printing plate contacts a printing target, and a method for producing a flexo printing plate. A region that extends 0.5 mm to 5 mm from a distal end side of the image portion in a printing direction is a lowered region having a height shorter than a height of the image portion other than the region, and the lowered region is gradually lowered toward a non-image portion in a direction orthogonal to the edge on the distal end side of the image portion.

## Description

### BACKGROUND OF THE INVENTION

### 1. Field of the Invention

The present invention relates to a flexo printing plate and a method for manufacturing a flexo printing plate.

### 2. Description of the Related Art

A flexo printing plate having a flexible relief forming layer made of a resin or rubber has relatively soft projections (image portions) for printing and can conform to various shapes. Therefore, a flexo printing plate is used for printing performed on printing targets made of various materials, thick printing targets, and the like.

During flexo printing performed using a flexo printing plate, a flexo printing plate is mounted on the peripheral surface of a cylindrical drum (plate cylinder), and ink is supplied to the flexo printing plate. In a state where the plate cylinder and an impression cylinder are being rotated, a printing target is inserted between the plate cylinder and the impression cylinder such that the flexo printing plate contacts the printing target. In this way, the ink is directly transferred to the printing target from the surface of a convex portion (image portion) of the printing plate, and an image is formed on the printing target.

During the flexo printing described above, according to the pattern formed by the image portion and a non-image portion, the printing plate repeatedly contacts or does not contact the printing target periodically. Therefore, due to the impact force exerted in a case where the distal end of the image portion of the printing plate contacts the printing target, so-called bouncing which is the vibration of the plate cylinder occurs. As a result, in a position close to the distal end of the image portion, the contact between the printing plate and the printing target is lost, and this leads to problems of the occurrence of transfer failure of the ink and the unevenness in the printed image.

As a solution to the problems, there is a suggestion that a layer having cushioning properties may be provided on the underlayer side of a printing plate so as to absorb the impact exerted in a case where an image portion contacts a printing target.

For example, JP2013-528513A describes that the bouncing can be reduced by adopting a constitution in which a rotation shaft of a plate cylinder has an inner cylindrical body formed of a first material, an intermediate sleeve formed of a second material, and an outer sleeve formed of a third material, and a Young's modulus of the second material is substantially lower than a Young's moduli of the first and third materials.

JP1998-501192A (JP-H10-501192A) describes the use of a double-sided tape having cushioning properties as a double-sided tape used for bonding a printing plate to a plate cylinder.

JP2006-326938A describes that a foaming resin layer is provided on an underlayer of a printing plate.

### SUMMARY OF THE INVENTION

In a case where a layer having cushioning properties is provided on the underlayer side of a printing plate, the softer the cushioning layer, the stronger the impact force-reducing effect. However, in a case where the cushioning layer is excessively soft, the uniformity of ink density in a solid portion deteriorates, and this leads to a problem of the occurrence of unevenness in the printed image.

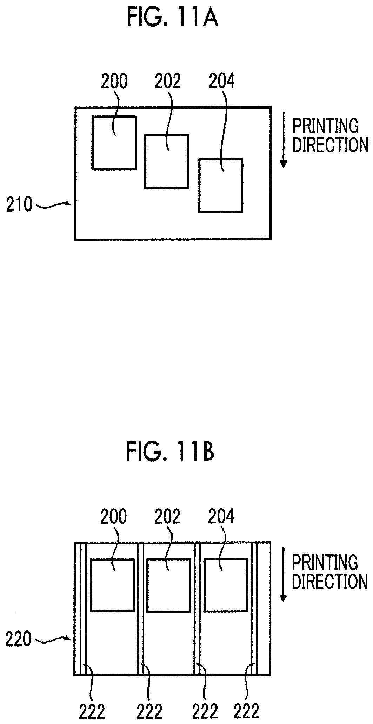

In addition to the above methods, the method of disposing image portions is considered. For example, as in a flexo printing plate 210 shown in Fig. 11A, a constitution is considered in which a plurality of image portions 200, 202, and 204 are disposed so as not to make the distal ends of these image portions aligned in a width direction of printing. Alternatively, as in a flexo printing plate 220 shown in Fig. 11B, a constitution is considered in which a plurality of image portions 200, 202, and 204 are disposed, and a solid obi portion 222 (so-called discarded obi) is provided between these image portions along a direction extending in a printing direction.

However, because of restriction on design, the aforementioned constitution in which the disposition of image portions is considered cannot be used in a case where a single dot image occupies a large area of the plate.

The present invention aims to solve the problems of the related art described above, and objects thereof are to provide a flexo printing plate, which makes it possible to print an image without unevenness by inhibiting bouncing that occurs due to an impact exerted in a case where the distal end of an image portion of a printing plate contacts a printing target, and to provide a method for manufacturing a flexo printing plate.

In order to achieve the aforementioned objects, the inventors of the present invention conducted a thorough study. As a result, the inventors found that by adopting a constitution in which a region that extends 0.5 mm to 5 mm from a distal end side of an image portion in a printing direction is a lowered region having a height shorter than a height of other regions, and the height of the lowered region is gradually lowered toward a non-image portion in the printing direction, it is possible to inhibit bouncing that occurs due to an impact exerted in a case where the distal end of the image portion of a printing plate contacts a printing target, and to print an image without unevenness. Based on what they had found, the inventors accomplished the present invention.

That is, the present invention provides a flexo printing plate and a method for manufacturing a flexo printing plate having the following constitution.
(1) A flexo printing plate comprising an image portion and a non-image portion, in which a region that extends 0.5 mm to 5 mm from a distal end side of the image portion in a printing direction is a lowered region having a height shorter than a height of the image portion other than the region, and the height of the lowered region is gradually lowered toward the non-image portion in the printing direction.
(2) The flexo printing plate described in (1), in which a maximum value of a lowering amount in the lowered region is 20 µm to 120 µm.
(3) The flexo printing plate described in (1) or (2), in which the lowered region is formed in the image portion adjacent to a non-image portion that continues 2 mm or further in a direction away from the edge of the image portion.
(4) A method for producing a flexo printing plate having an image portion and a non-image portion, comprising an image data obtainment step of obtaining original image data of an image to be printed, a first engraving image generation step of generating first engraving shape image data from the obtained original image data, a lowering mask generation step of generating lowering mask data for lowering a height of a part of the image portion by detecting a boundary between the image portion and the non-image portion from the original image data and based on the position of the boundary, and a second engraving image generation step of generating second engraving shape image data in which a region that extends 0.5 mm to 5 mm from the distal end side of the image portion in the printing direction is lowered, by applying the lowering mask data to the first engraving shape image data.
(5) The method for producing a flexo printing plate described in (4), in which a maximum value of a lowering amount determined by the lowering mask data is 20 µm to 120 µm.
(6) The method for producing a flexo printing plate described in (4) or (5), in which in the lowering mask data generation step, the lowering mask data is generated based on a position of a boundary of the image portion adjacent to the non-image portion that continues 2 mm or further in a direction away from the edge of the image portion.
(7) The method for producing a flexo printing plate described in any one of (4) to (6), in which in the first engraving image generation step, the original image data is converted into halftone dot image data, and the first engraving shape image data is generated based on the halftone dot image data.
(8) The method for producing a flexo printing plate descried in any one of (4) to (7), further comprising an engraving step of laser-engraving a flexo printing plate precursor based on the second engraving shape image data.

According to the present invention, it is possible to provide a flexo printing plate, which makes it possible to print an image without unevenness by inhibiting bouncing that occurs due to an impact exerted in a case where the distal end of an image portion of a printing plate contacts a printing target, and to provide a method for manufacturing a flexo printing plate.

### BRIEF DESCRIPTION OF THE DRAWINGS

Fig. 1A is schematic top view showing an example of a flexo printing plate according to the present invention, and Fig. 1B is an enlarged view showing a portion of a cross-section of the flexo printing plate shown in Fig. 1A taken along the line A-A.
Fig. 2 is a graph showing an example of a lowering amount in a lowered region.
Fig. 3A is a schematic top view showing another example of the flexo printing plate of the present invention, and Fig. 3B is a cross-sectional view of the flexo printing plate shown in Fig. 3A taken along the line B-B.
Fig. 4 is a flowchart for describing an example of a method for manufacturing a flexo printing plate of the present invention.
Fig. 5(A) is a schematic view showing an example of original image data, Fig. 5(B) is a graph showing a data level on the line B-B in the original image data of Fig. 5(A), and Fig. 5(C) is a graph showing lowering mask data generated based on the original image data of Fig. 5(A).
Fig. 6(A) is a schematic view showing another example of the original image data, Fig. 6(B) is a schematic view showing halftone dot image data converted from the original image data shown in Fig. 6(A), Fig. 6(C) is a schematic cross-sectional view showing the shape of one halftone dot of the halftone dot image data of Fig. 6(B), Fig. 6(D) is a schematic view showing engraving shape image data generated based on the halftone dot image data of Fig. 6(B), and Fig. 6(E) is a schematic cross-sectional view showing the shape of one halftone dot of the engraving shape image data of Fig. 6(D).
Fig. 7 is a view conceptually showing calender rolls for preparing a flexo printing plate precursor.
Fig. 8 is a view conceptually showing main portions of a flexo printing apparatus using the flexo printing plate according to the present invention.
Figs. 9A and 9B are graphs showing a relationship between a printing position and density.
Figs. 10(A) to 10(C) are views for describing bouncing that occurs in a case where flexo printing is performed using a flexo printing plate of the related art.
Figs. 11A and 11B are views for describing an example of flexo printing performed using a flexo printing plate of the related art.

### DESCRIPTION OF THE PREFERRED EMBODIMENTS

Hereinafter, a flexo printing plate and a method for manufacturing a flexo printing plate of the present invention will be specifically described based on suitable embodiments illustrated in the attached drawings.

In the following section, constituents will be described based on typical embodiments of the present invention in some cases, but the present invention is not limited to the embodiments.

In the present specification, a range of numerical values described using "to" means a range including the numerical values listed before and after "to" as a lower limit and an upper limit.

### [Flexo printing plate]

The flexo printing plate (hereinafter, simply referred to as "printing plate" as well) according to the present invention is a flexo printing plate in which a region that extends 0.5 mm to 5 mm from a distal end side of an image portion in a printing direction is a lowered region having a height smaller than a height of the image portion other than the region, and the lowered region is gradually lowered toward the non-image portion in the printing direction.

Hereinafter, the constitution of the flexo printing plate according to the present invention will be specifically described based on the attached drawings.

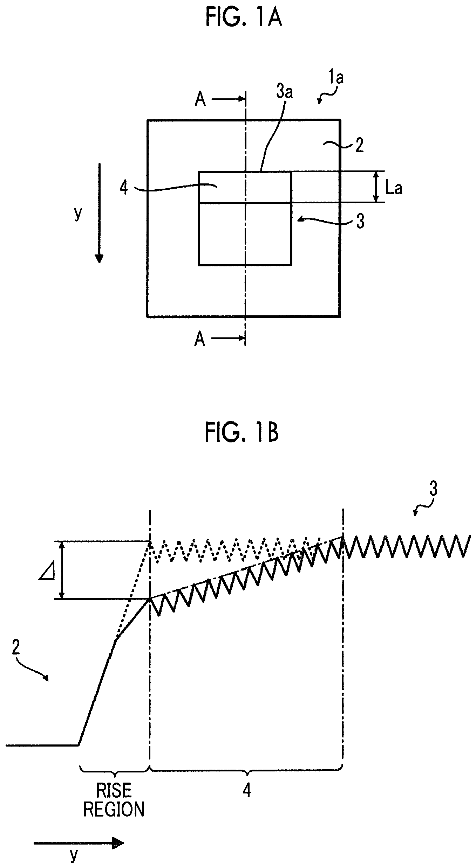

Fig. 1A is a top view schematically showing an example of the flexo printing plate of the present invention, and Fig. 1B is an enlarged view showing a portion of a cross-section taken along the line A-A in Fig. 1A. In Fig. 1B, the portion indicated by a broken line shows the shape of the flexo printing plate that has not yet been lowered.

As shown in Fig. 1A, a printing plate 1a as an example of the flexo printing plate according to the present invention has an image portion 3 and a non-image portion 2.

The image portion 3 is a region to which ink is applied and from which the ink is transferred to a printing substrate at the time of printing, that is, a region which forms an image at the time of printing. The non-image portion 2 is a region to which ink is not applied at the time of printing, that is, a region which does not form an image.

The image portion 3 includes a solid portion for performing printing as if painting a printing substrate by transferring ink to the whole surface of the substrate and/or a halftone dot portion which is constituted with a plurality of projection-like small dots and expresses the density (gradation) of an image printed on a printing target by varying the size or density of the small dots.

Generally, the small dots constituting the halftone dot portion are formed based on a predetermined number of screen lines (definition), for example, based on the number of screen lines of about 100 to 175 lines per inch (lpi).

The image portion 3 of the printing plate 1a as the flexo printing plate of the present invention has a lowered region 4 on the distal end side in the printing direction. In Fig. 1A, in a case where the direction indicated by the arrow y is regarded as the printing direction, a region of the image portion 3 that is on the upper side in the drawing is the lowered region 4.

The lowered region 4 is a region that extends 0.5 mm to 5 mm from the distal end side in the printing direction, and is formed such that the height thereof is shorter than the height of the image portion 3 other than the lowered region 4. The lowered region 4 has a constitution in which the lowered region 4 is gradually lowered toward the non-image portion 2 in a direction orthogonal to an edge 3a of the image portion 3 on the distal end side.

In the following description, a width of the lowered region 4 in the printing direction is denoted by La. That is, the width La is 0.5 mm to 5 mm.

In the example shown in Fig. 1B, the image portion 3 is a halftone dot portion formed of many convex small dots. In the lowered region 4, the small dots are formed such that an imaginary line (indicated by a dot-and-dash line in the drawing) that connects apexes of the small dots forming the halftone dot portion is lower than the height of the image portion 3 other than the lowered region 4 and is lowered toward the non-image portion 2 side.

Generally, as shown in Fig. 1B by the broken line, an image portion of a printing plate is formed such that the entirety of the image portion has a uniform height (in a case of a halftone dot portion, the top portions of all of small dots have a uniform height). Therefore, the printing plate 1 a of the present invention can be said to be a printing plate in which the height of the lowered region 4 that extends 0.5 mm to 5 mm from the distal end side in the printing direction is made lower than the height of the image portion indicated by the broken line.

Hereinafter, "image portion indicated by the broken line" will be referred to as "original image portion" as well.

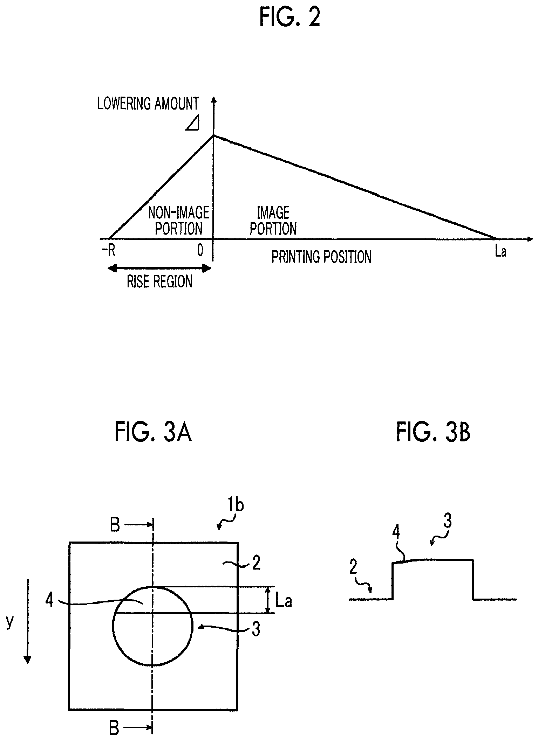

The difference in height between the image portion 3 other than the lowered region 4 and the lowered region 4 is a lowering amount Δ. That is, the lowering amount Δ can be said to be the difference in height between the original image portion and the lowered region 4. Fig. 2 shows the lowering amount Δ in the lowered region 4 of Fig. 1B.

As shown in Fig. 2, the lowering amount Δ is set such that based on the boundary between the non-image portion 2 and the image portion 3, that is, based on the position of the edge 3a of the image portion 3 on the distal end side, the lowering amount Δ becomes maximum in the position of the edge 3a on the distal end side, is reduced as the small dots separate from the non-image portion 2, and becomes zero in a position distant from the edge 3a on the distal end side by a distance La.

In the image portion of the printing plate, the small dots in the halftone dot portion having the same area ratio have the same height, and in some cases, the height of small dots vary between halftone dot portions having different area ratios. In these cases, in the lowered region 4, the small dots are formed such that the height of the lowered region 4 becomes shorter than the average height of the image portion 3 other than the lowered region 4.

In a case where the lowered region 4 is seen in a direction perpendicular to the printing plate, the area of the lowered region 4 in the image portion 3 is preferably shorter than the area of the image portion 3 other than the lowered region.

Furthermore, the lowered region 4 is preferably formed only on the distal end side of the image portion 3 in the printing direction.

In the example shown in Fig. 1B, from the viewpoint of securing the strength of the convex portion that becomes the image portion 3, the lateral surface of the convex portion slopes. Hereinafter, the lateral surface portion that slopes will be referred to as a rise region.

Accordingly, the rise region is formed such that it has a height shorter than the height of an original rise region indicated by the broken line. As shown in Fig. 2, the lowering amount Δ in the rise region is set such that the lowering amount Δ is reduced as the small dots separate from the edge 3a on the distal end side of the image portion 3 and becomes zero in a position distant from the edge 3a on the distal end side by a predetermined distance R.

The width of the rise region may be the same as the width of a rise region in a flexo printing plate of the related art.

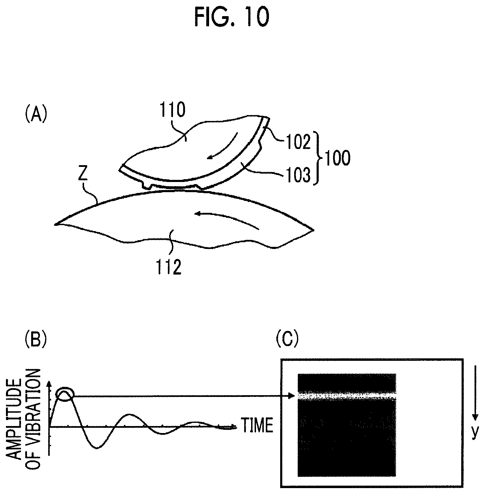

As described above, in a case where printing is performed using a flexo printing plate, due to an impact force exerted in a case where the distal end of an image portion of the printing plate contacts a printing target, the problem of the occurrence of bouncing arises. This problem will be specifically described using Figs. 10(A) to 10(C).

Fig. 10(A) is a partially enlarged schematic view of an example of a printing apparatus using a flexo printing plate of the related art. Fig. 10(B) is a graph schematically showing the vibration occurring in the printing apparatus of Fig. 10(A). Fig. 10(C) is a schematic view showing a printed image printed using the printing apparatus of Fig. 10(A).

In the printing apparatus shown in Fig. 10(A) that uses a flexo printing plate 100 of the related art, a printing plate 100 is mounted on the peripheral surface of a plate cylinder 110, a printing target Z is inserted into a nip portion formed of the plate cylinder 110 and an impression cylinder 112 and brought into contact with an image portion 103 of the printing plate 100, and ink is directly transferred to the printing target from the surface of the image portion 103 such that an image is formed on the printing target Z. Generally, printing is performed by adjusting the printing pressure such that a predetermined printing pressure is applied to the nip portion and that the image portion 103 of the printing plate 100 is indented by about 40 to 100 µm.

During the flexo printing of the related art, according to the pattern formed by the image portion 103 and the non-image portion 102, the printing plate repeatedly contact or does not contact the printing target Z periodically, and an impact force exerted in a case where the distal end of the image portion 103 of the printing plate 100 contacts the printing target is applied. Consequently, bouncing occurs between the printing plate 100 and the printing target Z, and hence the vibration shown in Fig. 10(B) occurs. In a case where the printing plate 100 becomes distant from the printing target Z due to the bouncing, and hence the contact between the printing plate 100 and the printing target Z is lost, the transfer failure of ink occurs, and this leads to a problem of the occurrence of unevenness in the printed image as shown in Fig. 10(C).

As a solution to the problem, there is a suggestion that a layer having cushioning properties may be provided on the underlayer side of the printing plate so as to absorb the impact exerted in a case where the image portion contacts the printing target. In a case where a layer having cushioning properties is provided on the underlayer side of the printing plate, the softer the cushioning layer, the stronger the impact force-reducing effect. However, in a case where the cushioning layer is excessively soft, the uniformity of ink density in a solid portion deteriorates, and this also leads to a problem of the occurrence of unevenness in the printed image.

In contrast, the printing plate 1a as the flexo printing plate of the present invention has a constitution in which the lowered region 4 that extends 0.5 mm to 5 mm from the distal end side of the image portion 3 in the printing direction is gradually lowered toward the non-image portion 2 in the printing direction.

Therefore, in a case where printing is performed using the printing plate 1a, it is possible to reduce the impact exerted in a case where the distal end of the image portion 3 of the printing plate 1a contacts the printing target Z. Accordingly, it is possible to inhibit the bouncing resulting from the contact between the image portion 3 and the printing target Z and to print an image without unevenness.

Herein, the maximum value of the lowering amount Δ in the lowered region 4, that is, the lowering amount Δ on the edge 3a on the distal end side of the image portion 3 may be appropriately set according to the printing pressure, the printing rate, the hardness of the plate, the hardness of a cushion tape, and the like.

The standard printing pressure applied during flexo printing is set such that the indentation amount becomes about 40 µm to 100 µm from kiss touch. Therefore, by setting the lowering amount Δ to be equal to or greater than 20 µm, it is possible to more reliably inhibit the bouncing. Furthermore, by setting the lowering amount Δ to be equal to or less than 120 µm, the occurrence of missing of ink can be inhibited. From the viewpoint described above, the lowering amount Δ is preferably 20 µm to 120 µm, and more preferably 40 µm to 100 µm.

It is preferable to form the lowered region 4 in the image portion 3 adjacent to the non-image portion 2 that continues 2 mm or further in a direction away from the edge of the image portion 3. That is, in a case where a distance between the image portions 3 adjacent to each other in the printing direction is equal to or greater than 2 mm, it is preferable to form the lowered region 4 on the distal end side of the image portion 3 on the downstream side in the printing direction.

In the flexo printing, a nip width is about 2 mm to 4 mm. Therefore, in a case where the distance between the image portions 3 adjacent to each other is less than 2 mm, while the image portion 3 on the upstream side is contacting the printing target Z, the image portion 3 on the downstream side contacts the printing target, and hence the bouncing hardly occurs. Consequently, the lowered region 4 does not need to be formed. Furthermore, in a case where the distance between the image portions 3 adjacent to each other is shorter than the nip width, if the lowered region 4 is formed in the image portion 3 on the downstream side, there is a concern about the occurrence of missing of ink.

Therefore, the lowered region 4 is preferably formed in the image portion 3 adjacent to the non-image portion 2 that continues 2 mm or further in a direction away from the edge of the image portion 3, and more preferably formed in the image portion 3 adjacent to the non-image portion 2 that continues 3 mm or further in a direction away from the edge of the image portion 3.

From the viewpoint of inhibition of bouncing, a stress distribution at the edge of the image, and the like, the width La of the lowered region 4 is 0.5 mm to 5 mm, preferably 1 mm to 5 mm, and more preferably 1 mm to 4 mm.

In the example shown in Fig. 1B, a constitution is adopted in which the height of the lowered region 4 linearly changes in the printing direction. However, as long as the lowered region 4 has a shape that is gradually lowered toward the non-image portion, the present invention is not limited to the constitution. For example, the lowered region 4 may have a shape that is step-wise lowered toward the non-image portion 2 or a shape that is lowered in the form of a curve.

In the example shown in Fig. 1A, the image portion 3 has a rectangular shape. However, the present invention is not limited thereto, and according to the image to be printed, it is possible to form the image portion 3 of various shapes such as a circular shape, an elliptical shape, a triangular shape, a polygonal shape, a letter shape, a shape of a number, and a shape of a symbol. At this time, as the lowered region 4, a region having the width La that extends from the very distal end portion in the printing direction is lowered. For example, in a case where the printing plate has a circular image portion 3 as a printing plate lb shown in Figs. 3A and 3B, a region having the width La that extends from the very distal end portion of the image portion 3 in the printing direction is the lowered region 4, and is gradually lowered toward the non-image portion 2. In Fig. 3B, the rise region is not shown.

In the example shown in Fig. 1B, a constitution is shown in which the image portion 3 and the lowered region 4 are halftone dot portions. However, the present invention is not limited thereto, and the image portion 3 and the lowered region 4 may be solid portions.

In a case where the image portion 3 is a halftone dot portion, the height, the shape, and the like of the small dots constituting the halftone dot portion are not particularly limited and may be the same as the height and the shape of the small dots of the halftone dot portion in a flexo printing plate of the related art.

### [Method for producing flexo printing plate]

Next, the method for producing a flexo printing plate of the present invention will be specifically described.

The method for producing a flexo printing plate of the present invention is a producing method including an image data obtainment step of obtaining original image data of an image to be printed, a first engraving image generation step of generating first engraving shape image data from the obtained original image data, a lowering mask generation step of generating lowering mask data for lowering a height of a portion of the image portion by detecting a boundary between the image portion and the non-image portion from the original image data and based on the position of the boundary, and a second engraving image generation step of generating second engraving shape image data in which a region that extends 0.5 mm to 5 mm from the distal end side of the image portions in the printing direction is lowered, by applying the lowering mask to the first engraving shape image data.

The method for producing a flexo printing plate of the present invention more preferably manufactures a flexo printing plate by laser-engraving a flexo printing plate precursor based on the generated second engraving shape image data.

Furthermore, in the first engraving image generation step, the original image data is preferably converted into halftone dot image data, and the first engraving shape image data is preferably generated based on the halftone dot image data.

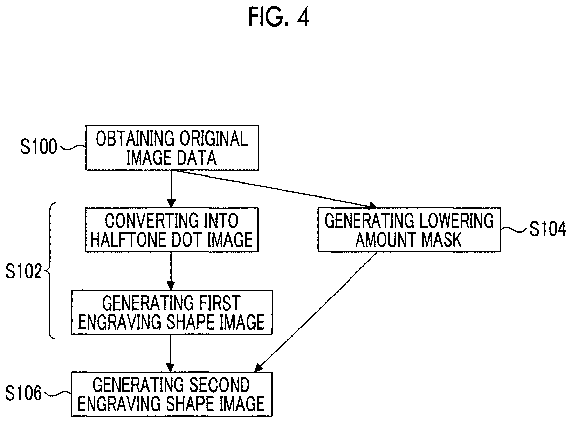

Fig. 4 is a flowchart showing an example of the method for producing a flexo printing plate of the present invention (hereinafter, referred to as "producing method of the present invention" as well).

First, in an image data obtainment step S100, original image data of a printing plate to be prepared is obtained.

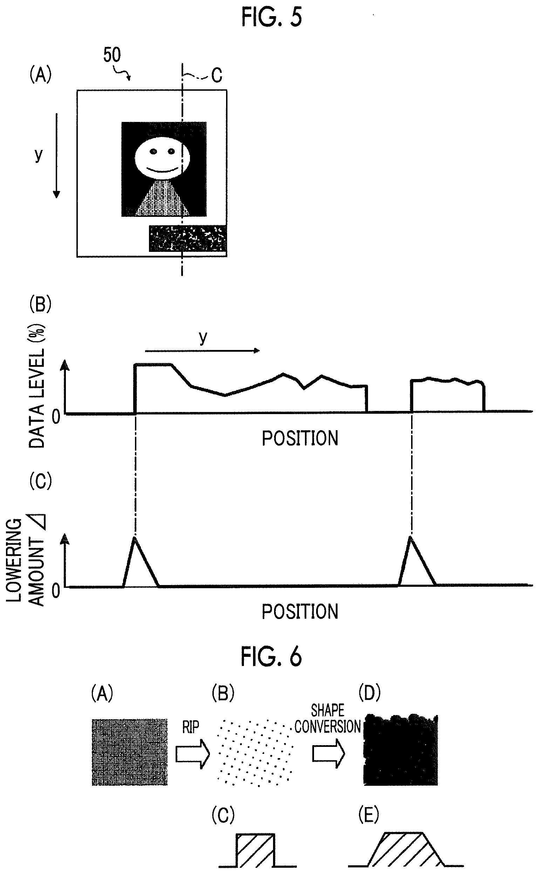

For example, original image data 50 shown in Fig. 5(A) is obtained. Fig. 5(B) is a graph showing a relationship between a data level and a position on a line C of the original image data 50.

In the graph shown in Fig. 5(B), the region in which the data level is 0% is a region which becomes a non-image portion, and the region in which the data level exceeds 0% becomes a region which becomes an image portion.

Then, in a first engraving image generation step S102, the obtained original image data is processed with a raster image processor (RIP) such that the data is converted into halftone dot image data, and the first engraving shape image data is generated based on the halftone dot image data.

Specifically, first, based on the data level of the original image data, the data is binarized. That is, by setting a halftone dot rate in each region of the image, the original image data is converted into halftone dot image data (see Figs. 6(A) and 6(B)).

Thereafter, based on the halftone dot image data, the small dots constituting the halftone dots (see Fig. 6(C)) are subjected to a process of adding a rise region or the like such that the data is converted into a shape to be engraved (see Fig. 6(E)), thereby generating the first engraving shape image data (see Fig. 6(D)).

Meanwhile, in a lowering mask generation step S104, from the original image data, image data is searched for each line in the printing direction, the position of the boundary between a non-image portion (region of a data level of 0%) and an image portion (region of a data level exceeds 0%) that are connected to each other is detected, and based on the position of the boundary, the lowering mask data is generated.

For example, first, by searching the image data on the line C of Fig. 5(A), the position of the boundary between a non-image portion and an image portion is detected at two sites (see Fig. 5(B)). Based on the detected position of the boundary, the lowering amount Δ for each position of the image is set on the basis of the maximum value of a predetermined lowering amount Δ, the width La of the lowered region, and the like. In this way, the data showing the relationship between the lowering amount Δ and the position as shown in Fig. 5(C) is generated.

By performing the aforementioned process for all lines of the original image data in the printing direction, the lowering mask data is generated.

The maximum value of the lowering amount Δ and the width La of the lowered region in the lowering mask data may be preset, or may be set according to the instruction input from an input device. As described above, the width La of the lowered region is preferably 0.5 mm to 5 mm, and the maximum value of the lowering amount Δ is preferably 20 µm to 120 µm.

In a case where the length of the non-image portion is found to be less than 2 mm by searching the image data in the lowering mask generation step, it is preferable that the lowering amount Δ is not set for the image portion adjacent to the downstream side of the non-image portion. That is, it is preferable to generate the lowering mask data by setting the lowering amount Δ based on the position of the boundary between an image portion adjacent to the upstream side and an image portion separating from the aforementioned image portion by a distance of equal to or longer than 2 mm.

Subsequently, in the second engraving image generation step, by applying the lowering mask data to the first engraving shape image data, a region that extends 0.5 mm to 5 mm from the distal end side of the image portion along the printing direction in the first engraving shape image data is lowered, thereby generating the second engraving shape image data.

Next, in the engraving step, by using the second engraving shape image data generated as above by adding the lowering amount Δ to the region on the distal end side of the image portion in the printing direction, the flexo printing plate precursor (hereinafter, referred to as "printing plate precursor" as well) is engraved, thereby preparing a flexo printing plate.

In the present invention, engraving is preferably performed using a laser. There is a certain relationship between the laser intensity and the engraving depth. By controlling the intensity, it is possible to engrave any shape in the printing plate precursor.

The laser engraving method is basically the same as the laser engraving method used in the method for producing a flexo printing plate of the related art.

As the laser engraving method, for example, it is possible to use a method in which a sheet-like printing plate precursor for laser engraving is wound around the outer peripheral surface of a cylindrical drum; the drum is rotated; a laser beam corresponding to the aforementioned output image data is emitted to the printing plate precursor from an exposure head; and the exposure head is caused to perform scanning at a predetermined pitch in a sub-scanning direction orthogonal to a main scanning direction such that a two-dimensional image is engraved (recorded) at a high speed on the surface of the printing plate precursor.

The type of the laser used in the laser engraving is not particularly limited, but an infrared laser is preferably used. By the irradiation of the infrared laser, molecules in the cured layer vibrate, and hence heat is generated. If a high-power laser such as a carbon dioxide laser or a YAG laser is used as the infrared laser, a large amount of heat is generated in the portion irradiated with the laser, and the molecules in the cured layer are cleaved or ionized. As a result, the cured layer is selectively removed, that is, engraved. The advantage of the laser engraving is that it enables three-dimensional control of the structures because the engraving depth can be arbitrarily set. For example, in a portion on which minute halftone dots are printed, by shallowly engraving the cured layer or by engraving the cured layer with forming shoulders, it is possible to prevent the relief from being inverted due to the printing pressure. Furthermore, in a groove portion on which fine outline letters are printed, by deeply engraving the cured layer, it is possible to prevent the ink from easily filling the grooves and to inhibit the outline letters from collapsing.

Particularly, in a case where engraving is performed using an infrared laser corresponding to the absorption wavelength of a photothermal conversion agent, the cured layer can be selectively removed with higher sensitivity, and hence a relief layer having a sharp image is obtained.

As the infrared laser, in view of productivity, costs, and the like, a carbon dioxide laser (CO₂ laser) or a semiconductor laser is preferable, and a semiconductor infrared laser with fiber (FC-LD) is particularly preferable. Generally, compared to the CO₂ laser, the semiconductor laser has higher laser oscillation efficiency, is less expensive, and can be further miniaturized. Furthermore, it is easy to make an array of the semiconductor lasers because of the small size thereof. In addition, by treating the fiber, the beam shape can be controlled.

The wavelength of the semiconductor laser is preferably 700 to 1,300 nm, more preferably 800 to 1,200 nm, even more preferably 860 to 1,200 nm, and particularly preferably 900 to 1,100 nm.

In a case where the optical fiber is additionally mounted on the semiconductor laser with fiber, the laser can efficiently emit laser beams, and accordingly, such a laser is effective for the laser engraving. Furthermore, by treating the fiber, the beam shape can be controlled. For example, it is possible to make the beam profile have a top-hat shape, and in this way, energy can be stably applied to the surface of the plate. Details of the semiconductor laser are described in "Laser Handbook, 2^{nd} Edition" edited by Laser Society of Japan, and in "Practical Laser Technology" written and edited by Institute of Electronics and Communication Engineers of Japan.

In addition, a plate-making apparatus including the semiconductor laser with fiber specifically described in JP2009-172658A and JP2009-214334A can be suitably used in the method for producing the flexo printing plate of the present invention.

In the present invention, the method for producing the flexo printing plate is not limited to laser engraving (direct laser engraving (DLE) method), and it is possible to use various known producing methods such as a laser ablation masking system (LAMS) method in which an image is graven on the surface of a printing plate precursor by using a laser and developed.

### [Flexo printing plate precursor]

The flexo printing plate precursor used in the present invention is not particularly limited as long as it is a known resin plate or rubber plate for flexo printing. Furthermore, the printing plate precursor may have a sheet shape or a cylindrical shape.

It is preferable that the printing plate precursor has the following resin sheet as a cured layer (relief forming layer).

### <Resin sheet>

The resin sheet is preferably a sheet which is obtained in a manner in which a curable resin composition containing at least a polymer having a monomer unit derived from diene-based hydrocarbon (hereinafter, referred to as "resin composition for forming a resin sheet" as well) is made into a sheet-shaped material and cured by the action of heat and/or light, and more preferably a sheet formed of the resin composition for forming a resin sheet which will be described later.

It is preferable that the resin sheet can be laser-engraved.

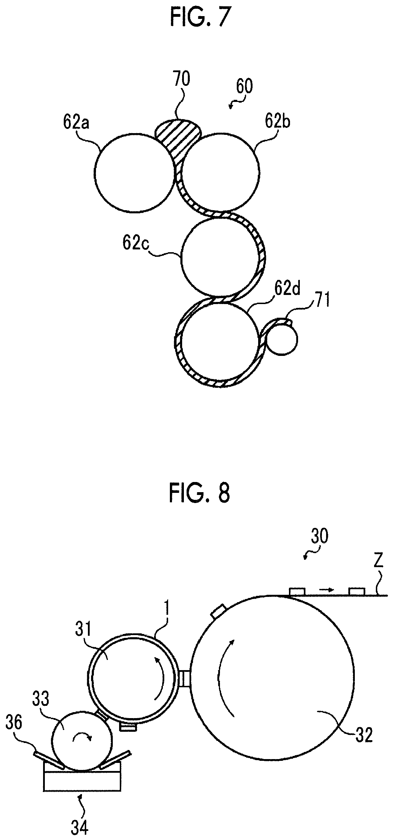

Preferred examples of methods for forming the resin sheet include a method of preparing the resin composition for forming a resin sheet, removing a solvent from the resin composition if necessary, and then melt-extruding the resin composition onto a support, a method of preparing the resin composition for forming a resin sheet, casting the resin composition onto a support, and removing a solvent by heating and drying the cast resin composition in an oven or the like, and a method of molding the resin composition into a sheet-shaped material by using calender rolls shown in Fig. 7.

In Fig. 7, calender rolls 60 have first to fourth rolls 62a to 62d, and the gap between the rolls, the roll temperature, and the rotation rate of the rolls can be set. By setting a kneaded material 70 between the rolls and molding the material by rolling, a resin sheet 71 can be obtained.

### <Support>

In a case where a support is used for forming the resin sheet, the material used in the support is not particularly limited as long as the material can be mounted on a printing cylinder. However, materials having high dimensional stability are preferably used, and examples thereof include a metal such as steel, stainless steel, or aluminum; a plastic resin such as polyester (for example, polyethylene terephthalate (PET), polybutylene terephthalate (PBT), or polyacrylonitrile (PAN)), or polyvinyl chloride; synthetic rubber such as styrene-butadiene rubber; and a plastic resin (such as an epoxy resin or a phenol resin) reinforced with glass fiber. As the support, a PET film or a steel substrate is preferably used.

The resin composition for forming a resin sheet used in the present invention can be manufactured by, for example, dissolving or dispersing a polymer having a monomer unit derived from diene-based hydrocarbon, a polymerizable compound, aromatics, a plasticizer, and the like in an appropriate solvent and then dissolving a cross-linking agent, a polymerization initiator, a cross-linking accelerator, and the like therein. From the viewpoint of the ease of forming the resin sheet, the thickness accuracy of the obtained cylindrical printing plate precursor, and the handling of the resin sheet, at least a portion of the solvent component and preferably the entirety of the solvent component needs to be removed at the stage of producing a cylindrical printing plate precursor. Therefore, as the solvent, an organic solvent having appropriate volatility is preferable.

Next, the components contained in the resin sheet and the resin composition for forming a resin sheet will be described.

### (Polymer having monomer unit derived from diene-based hydrocarbon)

It is preferable that the resin sheet used in the present invention contains a polymer having a monomer unit derived from diene-based hydrocarbon (hereinafter, referred to as "specific polymer" as well) as an essential component.

The weight-average molecular weight of the specific polymer is preferably 5,000 to 1,600,000, more preferably 10,000 to 1,000,000, and even more preferably 15,000 to 600,000. In a case where the weight-average molecular weight is equal to or greater than 5,000, the shape retaining properties of the polymer as a simple resin becomes excellent. It is preferable that weight-average molecular weight is equal to or less than 1,600,000, because then the polymer easily dissolves in a solvent, and it is easy to prepare a resin composition for laser engraving.

In the present invention, the weight-average molecular weight is measured by a gel permeation chromatography (GPC) and expressed in terms of standard polystyrene. Specifically, for example, for GPC, HLC-8220 GPC (manufactured by Tosoh Corporation), three columns consisting of TSKgeL Super HZM-H, TSKgeL Super HZ4000, and TSKgeL Super HZ 2000 (manufactured by Tosoh Corporation, 4.6 mm ID × 15 cm), and tetrahydrofuran (THF) as an eluent are used. Furthermore, GPC is performed using an IR detector under the conditions of a sample concentration of 0.35% by mass, a flow rate of 0.35 ml/min, sample injection amount of 10 µL, and a measurement temperature of 40°C. In addition, a calibration curve is prepared from 8 samples of "Standard Sample TSK standard, polystyrene" manufactured by Tosoh Corporation: "F-40", "F-20", "F-4", "F-1", "A-5000", "A-2500", "A-1000", and "n-propylbenzene".

The specific polymer may be a specific polymer having a monomer unit derived from unconjugated diene-based hydrocarbon, but is preferably a specific polymer having a monomer unit derived from conjugated diene-based hydrocarbon.

### (Specific polymer having monomer unit derived from conjugated diene-based hydrocarbon)

Preferred examples of the specific polymer having a monomer unit derived from conjugated diene-based hydrocarbon include a polymer obtained by polymerizing conjugated diene-based hydrocarbon, a copolymer obtained by polymerizing conjugated diene-based hydrocarbon with other unsaturated compound are preferably with a monoolefin-based unsaturated compounds, and the like. The aforementioned polymer or copolymer may be modified. For example, a reactive group such as (meth)acryloyl group may be introduced into the terminal thereof, or a portion of the internal olefin may be hydrogenated. In the following description, the polybutadiene in which a portion of the internal olefin is hydrogenated will be referred to as "partially hydrogenated polybutadiene" as well, and the polyisoprene in which a portion of the internal olefin is hydrogenated likewise will be referred to as "partially hydrogenated polyisoprene" as well. The copolymer is not particularly limited, and may be a random polymer, a block copolymer, or a graft polymer.

Specific examples of the aforementioned conjugated diene-based hydrocarbon include 1,3-butadiene, isoprene, and the like. One kind of these compounds are used singly, or two or more kinds thereof are used in combination.

Specific examples of the aforementioned monoolefin-based unsaturated compounds include styrene, α-methylstyrene, o-methylstyrene, p-methylstyrene, isobutene, vinyl chloride, vinylidene chloride, (meth)acrylamide, (meth)acrylamide vinyl acetate, (meth)acrylic acid ester, (meth)acrylic acid, and the like.

The polymer obtained by polymerizing conjugated diene-based hydrocarbon or the copolymer obtained by polymerizing conjugated diene-based hydrocarbon with a monoolefin-based unsaturated compound is not particularly limited, and specific examples thereof include a butadiene polymer, an isoprene polymer, a styrene-butadiene copolymer, a styrene-isoprene copolymer, an acrylic acid ester-isoprene copolymer, a copolymer of methacrylic acid ester and the aforementioned conjugated diene, an acrylonitrile-butadiene-styrene copolymer, a styrene-isoprene-styrene block copolymer, a styrene-butadiene-styrene block copolymer, an isobutene-isoprene copolymer (butyl rubber), and the like.

These polymers may be subjected to emulsion polymerization or solution polymerization.

In the present invention, the specific polymer may have an ethylenically unsaturated group on the terminal thereof, and may have a partial structure represented by the following Formula (A-1).

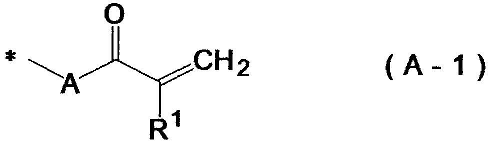

(In Formula (A-1), R¹ represents a hydrogen atom or a methyl group, A represents O or NH, and * represents a binding position in which the structure is bonded to other structures.)

In Formula (A-1), A preferably represents O.

That is, the specific polymer may have a (meth)acryloyloxy group or a (meth)acrylamide group in a molecule. The specific polymer more preferably has a (meth)acryloyloxy group.

The specific polymer may have the partial structure represented by Formula (A-1) on the terminal of a main chain or in a side chain. It is preferable that the specific polymer has the partial structure of the terminal of the main chain.

From the viewpoint of printing durability, it is preferable that the specific polymer has two or more partial structures represented by Formula (A-1) in a molecule.

Examples of the specific polymer having the partial structure represented by Formula (A-1) include polyolefin (meth)acrylate obtained by reacting a hydroxyl group of a hydroxyl group-containing polyolefin with an ethylenically unsaturated group-containing compound (for example, BAC-45 (manufactured by OSAKA ORGANIC CHEMICAL INDUSTRY LTD), TEA-1000, TE-2000, EMA-3000 (manufactured by NIPPON SODA CO., LTD.)), such as polybutadiene di(meth)acrylate, partially hydrogenated polybutadiene di(meth)acrylate, polyisoprene di(meth)acrylate, and partially hydrogenated polyisoprene (meth)acrylate.

Examples of the specific polymer also preferably include modified polyolefin obtained by modifying polyolefin such that an ethylenically unsaturated bond is introduced into the polyisoprene (for example, methacrylate-introduced polyolefin (KURAPRENE UC-203 and UC-102 (manufactured by KURARAY CO., LTD.)).

### (Polymer having monomer unit derived from butadiene and/or isoprene)

In the present invention, it is preferable that the specific polymer is a polymer having a monomer unit derived from butadiene and/or isoprene.

Specific examples of the polymer include polybutadiene (butadiene rubber), partially hydrogenated polybutadiene, terminal-modified polybutadiene, polyisoprene (isoprene rubber), partially hydrogenated polyisoprene, terminal-modified polyisoprene, styrene-butadiene rubber (SBR), a styrene-butadiene-styrene triblock copolymer (SBS), an acrylonitrile-butadiene-styrene copolymer (ABS), a styrene-isoprene-styrene triblock copolymer (SIS), an isoprene/butadiene copolymer, and the like.

"Terminal-modified" means that the terminal of the main chain or the side chain is modified with an amide group, a carboxyl group, a hydroxyl group, a (meth)acryloyl group, a glycidyl group, or the like.

Among these, polybutadiene, partially hydrogenated polybutadiene, hydroxyl group-terminated polybutadiene, glycidyl ether-modified polybutadiene, polyisoprene, partially hydrogenated polyisoprene, terminal-modified polyisoprene, hydroxyl group-terminated polyisoprene, glycidyl ether-modified polyisoprene, SBS, and SIS are preferable.

The proportion of the monomer unit derived from butadiene, isoprene, or hydrogenated butadiene or isoprene is preferably equal to or higher than 30 mol% in total, more preferably equal to or higher than 50 mol% in total, and even more preferably equal to or higher than 80 mol% in total.

It is known that isoprene is polymerized by 1,2-, 3,4-, or 1,4-addition depending on the catalyst or the reaction condition. In the present invention, the polyisoprene polymerized by any of the aforementioned addition pathways may be used. From the viewpoint of obtaining desired elasticity, it is particularly preferable that the specific polymer contains cis-1,4-polyisoprene as a main component. In a case where the specific polymer is polyisoprene, the content of the cis-1,4-polyisoprene is preferably equal to or greater than 50% by mass, more preferably equal to or greater than 65% by mass, even more preferably equal to or greater than 80% by mass, and particularly preferably equal to or greater than 90% by mass.

As the polyisoprene, natural rubber may be used. Furthermore, commercially available polyisoprene can be used, and examples thereof include a NIPOL IR series (manufactured by ZEON CORPORATION).

It is known that butadiene is polymerized by 1,2- or 1,4-addition depending on the catalyst or the reaction condition. In the present invention, the polybutadiene polymerized by any of the aforementioned addition pathways may be used. From the viewpoint of obtaining desired elasticity, it is more preferable that the specific polymer contains 1,4-polybutadiene as a main component.

In a case where the specific polymer is polybutadiene, the content of 1,4-polybutadiene is preferably equal to or greater than 50% by mass, more preferably equal to or greater than 65% by mass, even more preferably equal to or greater than 80% by mass, and particularly preferably equal to or greater than 90% by mass.

The content of a cis-isomer or a trans-isomer is not particularly limited. From the viewpoint of expressing rubber elasticity, a cis-isomer is preferable. The content of cis-1,4-polybutadiene is preferably equal to or greater than 50% by mass, more preferably equal to or greater than 65% by mass, even more preferably equal to or greater than 80% by mass, and particularly preferably equal to or greater than 90% by mass.

As polybutadiene, commercially available products may be used, and examples thereof include an NIPOL BR series (manufactured by ZEON CORPORATION), a UBEPOL BR series (manufactured by UBE INDUSTRIES, LTD.), and the like.

### (Specific polymer having monomer unit derived from unconjugated diene-based hydrocarbon)

The specific polymer may be a specific polymer having a monomer unit derived from unconjugated diene-based hydrocarbon.

Examples of the specific polymer preferably include a copolymer obtained by polymerizing unconjugated diene-based hydrocarbon with other unsaturated compounds and preferably with an α olefin-based unsaturated compound, and the like. The copolymer is not particularly limited, and may be a random polymer, a block copolymer, or a graft polymer.

Specific examples of the unconjugated diene-based hydrocarbon include dicyclopentadiene, 1,4-hexadiene, cyclooctadiene, methylene norbornene, ethylidene norbornene, and the like. Among these, dicyclopentadiene and ethylidene norbornene are preferable, and ethylidene norbornene is more preferable. These compounds are used singly, or two or more kinds thereof are used in combination.

Specific examples of the aforementioned monoolefin-based unsaturated compound include α-olefin having 2 to 20 carbon atoms such as ethylene, propylene, 1-butene, 1-hexene, and 4-methyl-pentene. Among these, ethylene and propylene are preferable. It is more preferable to use ethylene and propylene in combination. These compounds are used singly or used in combination of two or more kinds thereof.

The polymer obtained by polymerizing the conjugated diene-based hydrocarbon or the copolymer obtained by polymerizing conjugated diene-based hydrocarbon with an α-olefin-based unsaturated compound is not particularly limited. As the polymer or the copolymer, an ethylene-α olefin-diene copolymer is preferable, and ethylene-propylene-diene rubber (EPDM) is more preferable.

Among the above, as the specific polymer, styrene-butadiene rubber, butadiene rubber, isoprene rubber, or ethylene-propylene-diene rubber is preferable, and butadiene rubber is more preferable.

The specific polymer is preferably a polymer in which the main chain mainly contains isoprene or butadiene as a monomer unit. Furthermore, a portion of the specific polymer may be hydrogenated and converted into a saturated bond. In addition, the middle or the terminal of the main chain of the polymer may be modified with amide, a carboxyl group, a hydroxyl group, a (meth)acryloyl group, or the like or may be epoxylated.

Among the above examples, as the specific polymer, from the viewpoint of solubility in a solvent or handleability, polybutadiene, polyisoprene, and an isoprene/butadiene copolymer are preferable, polybutadiene and polyisoprene are more preferable, and polybutadiene is even more preferable.

From the viewpoint of expressing flexibility and rubber elasticity, the glass transition temperature (Tg) of the specific polymer is preferably equal to or lower than 20°C.

The glass transition temperature of the specific polymer is measured according to JIS K 7121-1987 by using a differential scanning calorimeter (DSC).

In a case where the specific polymer has two or more glass transition temperatures, it is preferable that at least one of them is equal to or lower than 20°C. It is more preferable that all of the glass transition temperatures are equal to or lower than 20°C.

In the present invention, the SP value of the specific polymer is preferably 14.0 to 18.0 MPa^{1/2}, more preferably 15.0 to 17.5 MPa^{1/2}, and even more preferably 16.0 to 17.5 MPa^{1/2}.

The SP value equals the square root of cohesive energy density of a molecule. The SP value shows the magnitude of intermolecular cohesive force, and is a parameter of polarity.

It is preferable that the SP value is within the above range, because then appropriate adhesiveness with respect to a urethane-based adhesive is obtained.

The SP value is calculated based on the Okitsu method described in The Journal of The Adhesion Society of Japan, 29(3), 1993, 204-211.

The specific polymer is preferably an elastomer or a plastomer. In a case where the specific polymer is an elastomer or a plastomer, if a printing plate precursor for laser engraving obtained from the specific polymer is made into a sheet-like precursor or a cylindrical precursor, excellent thickness accuracy or dimensional accuracy can be achieved. Furthermore, it is preferable that the specific polymer is an elastomer or a plastomer, because then necessary elasticity can be imparted to the flexo printing plate.

In the present invention, "plastomer" means a polymer substance having the properties of easily performing flow deformation by heating and of being able to be solidified into the deformed shape by cooling, as describe in "New Edition of Polymer Dictionary" (The Society of Polymer Science, Japan, Asakura Publishing Co., Ltd., 1988). "Plastomer" is a term of contrast to "elastomer" (a substance having the properties of being instantaneously deformed according to an external force in a case where an external force is applied thereto and restoring the original shape in a short time in a case where the external force is removed). The plastomer is a substance which does not perform elastic deformation unlike the elastomer while easily performs plastic deformation.

In the present invention, the plastomer means a substance which can be deformed such that the size thereof increases up to 200% with small external force at room temperature (20°C) provided that the original size of the plastomer is regarded as being 100%, and does not shrink to such a degree that the size becomes equal to or less than 130% even if the external force is removed. The small force specifically refers to the external force at which the tensile strength becomes 1 to 100 MPa. More specifically, the plastomer means a substance having properties in which, in a case where a dumbbell-shaped No. 4 test piece specified in JIS K 6251-1993 is used based on the tensile permanent set testing methods of JIS K 6262-1997, in a tensile test performed at 20°C, the test piece can be elongated without breakage until the distance between marker lines marked before the tensile test doubles; and in a case where the test piece is held as is for 60 minutes at a point in time when the distance between marker lines marked before the tensile test doubles, the external tensile force is removed, and then the test piece is allowed to stand for 5 minutes, the tensile permanent set measured at this time is equal to or higher than 30%. In the present invention, all of the testing conditions were based on the tensile permanent set testing methods of JIS K 6262-1997, except that the dumbbell-shaped No. 4 test piece specified in JIS K 6251-1993 was used, the holding time was set to be 60 minutes, and the temperature of the testing room was set to be 20°C.

A polymer which cannot be measured in the aforementioned method, that is, a polymer which is deformed even if external tensile force is not applied thereto and does not restore its original shape in a tensile test or a polymer which is broken in a case where the small external force used at the time of measurement described above is applied thereto corresponds to the plastomer.

In the present invention, the glass transition temperature (Tg) of the polymer plastomer is less than 20°C. In a case where the polymer has two or more Tg's, all of Tg's are less than 20°C. Tg of the polymer can be measured by differential scanning calorimetry (DSC).

In the present invention, "elastomer" means a polymer which can be elongated until the distance between marker lines doubles in the aforementioned tensile test and having a tensile permanent set, measured 5 minutes after the external tensile force is removed, of less than 30%.

The viscosity of the specific polymer of the present invention measured at 20°C is preferably 10 Pa·s to 10 kPa·s, and more preferably 50 Pa·s to 5 kPa·s. In a case where the viscosity is within the above range, the resin composition is easily molded into a sheet-shaped material, and the process becomes simple. In the present invention, in a case where the specific polymer is a plastomer, if the resin composition for forming a resin sheet is molded into a sheet-shaped material, excellent thickness accuracy or dimensional accuracy can be achieved.

In the present invention, one kind of the specific polymer may be used singly, or two or more kinds thereof may be used in combination.

The total content of the specific polymer in the resin sheet used in the present invention is, with respect to the total mass of the solid content of the resin sheet, preferably 5% to 90% by mass, more preferably 15% to 85% by mass, and even more preferably 30% to 80% by mass.

The total content of the specific polymer in the resin composition for forming a resin sheet used in the present invention is, with respect to the total mass of the solid content of the resin composition, preferably 5% to 90% by mass, more preferably 15% to 85% by mass, and even more preferably 30% to 80% by mass. In a case where the content of the specific polymer is equal to or greater than 5% by mass, printing durability enough for the obtained cylindrical printing plate to be used as a printing plate is obtained. In a case where the content of the specific polymer is equal to or less than 90% by mass, the amount of other components does not become insufficient, and flexibility enough for the prepared cylindrical printing plate to be used as a printing plate can be obtained.

"Total mass of the solid content" means the total mass determined in a case where volatile components such as a solvent are excluded from the resin sheet or the resin composition for forming a resin sheet.

It is preferable that the resin sheet and the resin composition for forming a resin sheet used in the present invention contains a polymerization initiator, a photothermal conversion agent, a solvent, and other components. Hereinafter, these components will be specifically described.

### (Polymerization initiator)

In the present invention, it is preferable that the resin composition for laser engraving is formed using the resin composition for forming a resin sheet containing a polymerization initiator. In a case where the resin composition for forming a resin sheet contains a polymerization initiator, the cross-linking of the specific polymer and the ethylenically unsaturated bonds contained in the polymerizable compound which will be described later is accelerated.

As the polymerization initiator, the compounds known to those in the related art can be used without limitation. Although any of a photopolymerization initiator and a thermal polymerization initiator can be used, a thermal polymerization initiator is preferable because this compound makes it possible to form a cross-link by using a simple device. Hereinafter, a radical polymerization initiator as a preferred polymerization initiator will be specifically described, but the present invention is not limited thereto.

In the present invention, specific examples of preferred polymerization initiators include (a) aromatic ketones, (b) onium salt compound, (c) organic peroxide, (d) thio compound, (e) hexaaryl biimidazole compound, (f) ketoxime ester compound, (g) borate compound, (h) azinium compound, (i) metallocene compound, (j) active ester compound, (k) carbon-halogen bond-containing compound, (1) azo-based compound, and the like. Specific examples of (a) to (1) will be shown below, but the present invention is not limited thereto.

In the present invention, from the viewpoint of improving the engraving sensitivity and the relief edge shape in a case where the composition is used for a resin sheet, (c) organic peroxide and (1) azo-based compound are more preferable, and (c) organic peroxide is particularly preferable.

As (a) aromatic ketones, (b) onium salt compound, (d) thio compound, (e) hexaaryl biimidazole compound, (f) ketoxime ester compound, (g) borate compound, (h) azinium compound, (i) metallocene compound, (j) active ester compound, and (k) carbon-halogen bond-containing compound described above, the compounds exemplified in paragraphs [0074] to [0118] in JP2008-63554A can be preferably used.

As (c) organic peroxide and (1) azo-based compound, the following compounds are preferable.

### (c) Organic peroxide

As (c) organic peroxide preferred as the thermal polymerization initiator which can be used in the present invention, peroxyester-based compounds such as 3,3 '4,4'-tetra(t-butylperoxycarbonyl)benzophenone, 3,3'4,4'-tetra(t-amylperoxycarbonyl)benzophenone, 3,3'4,4' -tetra(t-hexylperoxycarbonyl)benzophenone, 3,3'4,4'-tetra(t-octylperoxycarbonyl)benzophenone, 3,3'4,4'-tetra(cumylperoxycarbonyl)benzophenone, 3,3'4,4'-tetra(p-isopropylcumylperoxycarbonyl)benzophenone, di-t-butyldiperoxyisophthalate, t-butylperoxybenzoate, t-butylperoxy-3-methylbenzoate, t-butylperoxylaurate, t-butylperoxypivalate, t-butylperoxy-2-ethylhexanoate, t-butylperoxy-3,5,5-trimethylhexanoate, t-butylperoxyneoheptanoate, t-butylperoxyneodecanoate, t-butylperoxyacetate, α,α'-di(t-butylperoxy)diisopropylbenzene, t-butylcumylperoxide, di-t-butylperoxide, t-butylperoxyisopropylmonocarbonate, and t-butylperoxy-2-ethylhexylmonocarbonate are preferable. Among these, from the viewpoint of excellent compatibility, t-butylperoxybenzoate is particularly preferable.

### (1) Azo-based compound

Examples of (1) azo-based compound preferred as the polymerization initiator which can be used in the present invention include 2,2'-azobisisobutyronitrile, 2,2'-azobispropionitrile, 1,1'-azobis(cyclohexane-1-carbonitrile), 2,2'-azobis(2-methylbutyronitrile), 2,2'-azobis(2,4-dimethylvaleronitrile), 2,2'-azobis(4-methoxy-2,4-dimethylvaleronitrile), 4,4'-azobis(4-cyanovalerate), dimethyl 2,2'-azobisisobutyrate, 2,2'-azobis(2-methylpropionamidoxime), 2,2'-azobis[2-(2-imidazolin-2-yl)propane], 2,2'-azobis {2-methyl-N-[1,1-bis(hydroxymethyl)-2-hydroxyethyl]propionamide}, 2,2'-azobis[2-methyl-N-(2-hydroxyethyl)propionamide], 2,2'-azobis(N-butyl-2-methylpropionamide), 2,2'-azobis(N-cyclohexyl-2-methylpropionamide), 2,2'-azobis[N-(2-propenyl)-2-methylpropionamide], 2,2'-azobis(2,4,4-trimethylpentane), and the like.

In the present invention, from the viewpoint of improving the cross-linking properties of the resin sheet and the engraving sensitivity, (c) organic peroxide described above is particularly preferred as the polymerization initiator used in the present invention.

From the viewpoint the engraving sensitivity, an aspect is particularly preferable in which (c) organic peroxide is combined with the photothermal conversion agent which will be described later.

In a case where the resin sheet is cured through thermal cross-linking by using an organic peroxide, the unreacted organic peroxide not being involved in the generation of a radical remains. The remaining organic peroxide functions as a self-reactive additive and is decomposed in an exothermic way at the time of laser engraving. Presumably, as a result, the released heat may be added to the radiated laser energy, and hence the engraving sensitivity may be improved.

The aforementioned effect is markedly exhibited in a case where carbon black is used as the photothermal conversion agent for the following reason, although the mechanism will be specifically explained later in the description of the photothermal conversion agent. It is considered that the heat generated from carbon black may also be transferred to (c) organic peroxide, and as a result, heat may be released not only from carbon black but also from the organic peroxide, and hence the thermal energy supposed to be used for the decomposition of the specific polymer or the like may be synergistically generated.

In the present invention, only one kind of polymerization initiator may be used, or two or more kinds thereof may be used in combination.

The content of the polymerization initiator in the resin sheet used in the present invention is, with respect to the total mass of the solid content, preferably 0.01% to 30% by mass, more preferably 0.1 % to 20% by mass, and even more preferably 1% to 15% by mass.

It is preferable that the content of the polymerization initiator in the resin composition for forming a resin sheet used in the present invention is, with respect to the total mass of the solid content, preferably 0.01% to 30% by mass, more preferably 0.1% to 20% by mass, and even more preferably 1% to 15% by mass. It is preferable that the content is within the above range, because then the curing properties (cross-linking properties) become excellent, the relief edge shape obtained at the time of laser engraving becomes excellent, and the rinsing properties become excellent.

### (Photothermal conversion agent)

It is preferable that the resin sheet and the resin composition for forming a resin sheet used in the present invention further contain a photothermal conversion agent. That is, it is considered that, by absorbing the laser light and releasing heat, the photothermal conversion agent in the present invention may accelerate the thermal decomposition of the cured material at the time of laser engraving. Therefore, it is preferable to select a photothermal conversion agent that absorbs light having the wavelength of the laser used for engraving.

In a case where a laser (a YAG laser, a semiconductor laser, a fiber laser, a surface emitting laser, or the like) emitting infrared rays at 700 nm to 1,300 nm is used as a light source for laser-engraving the resin sheet used in the present invention, it is preferable to use a compound having a maximum absorption wavelength at 700 to 1,300 nm as the photothermal conversion agent.

In the present invention, various dyes or pigments are used as the photothermal conversion agent.

Among the photothermal conversion agents, as dyes, commercially available dyes and known dyes described in documents such as "Dye Handbook" (edited by The Society of Synthetic Organic Chemistry, Japan, 1970) can be used. Specific examples thereof include dyes having a maximum absorption wavelength at 700 to 1,300 nm. Examples thereof preferably include dyes such as an azo dye, a metal complex salt azo dye, pyrazolone azo dye, a naphthoquinone dye, an anthraquinone dye, a phthalocyanine dye, a carbonium dye, a diimonium compound, a quinoneimine dye, a methine dye, a cyanine dye, a squarylium dye, a pyrylium salt, and a metal thiolate complex. Examples of dyes which can be preferably used in the present invention include a cyanine-based dye such as a heptamethine cyanine dye, an oxonol-based dye such as pentamethine oxonol dye, a phthalocyanine-based dye, and the dyes described in paragraphs[0124] to [0137] in JP2008-63554A.

Among the photothermal conversion agents used in the present invention, as pigments, commercially available pigments and the pigments described in the color index (C. I.) handbook, "Latest Pigment Handbook" (edited by The Society of Pigment Technology, Japan, 1977), "Latest Application Technology of Pigment" (published by CMC Publishing Co., Ltd., 1986), and "Printing Ink Technology" (published by CMC Publishing Co., Ltd., 1984) can be used. Furthermore, as pigments, the pigments described in paragraphs [0122] to [0125] in JP2009-178869A can be exemplified.

Among these pigments, carbon black is preferable.

Any type of carbon black including those graded by ASTM can be used regardless of the purpose (for example, carbon black for coloring, rubber, batteries, and the like) as long as the dispersibility thereof in the composition is stable. Carbon black includes, for example, furnace black, thermal black, channel black, lamp black, acetylene black, and the like. Herein, a black colorant such as carbon black is easily dispersed. Therefore, if necessary, carbon black can be used in the form of a color chip or color paste obtained by dispersing in advance the pigment in nitrocellulose, a binder, or the like by using a dispersant. The chip or paste is easily available as commercial products. Examples of carbon black also include those described in paragraphs [0130] to [0134] in JP2009-178869A.

In the resin sheet and the resin composition for forming a resin sheet used in the present invention, only one kind of photothermal conversion agent may be used, or two or more kinds of thereof may be used in combination.

The content of the photothermal conversion agent in the resin sheet greatly varies with the magnitude of a molecular extinction coefficient inherent to the molecule of the photothermal conversion agent. However, the content of the photothermal conversion agent is preferably within a range of 0.01% to 30% by mass, more preferably 0.05% to 20% by mass, and particularly preferably 0.1% to 10% by mass of the total mass of the solid content.

The content of the photothermal conversion agent in the resin composition for forming a resin sheet greatly varies with the magnitude of a molecular extinction coefficient inherent to the molecule of the photothermal conversion agent. However, the content of the photothermal conversion agent is preferably within a range of 0.01% to 30% by mass, more preferably 0.05% to 20% by mass, and particularly preferably 0.1% to 10% by mass of the total mass of the solid content.

### (Solvent)

The resin composition for forming a resin sheet used in the present invention may contain a solvent.

It is preferable to use an organic solvent as the solvent.

Specific examples of preferred aprotic organic solvents include acetonitrile, tetrahydrofuran, dioxane, toluene, propylene glycol monomethyl ether acetate, methyl ethyl ketone, acetone, methyl isobutyl ketone, ethyl acetate, butyl acetate, ethyl lactate, N,N-dimethylacetamide, N-methylpyrrolidone, and dimethyl sulfoxide.

Specific examples of preferred organic protic solvents include methanol, ethanol, 1-propanol, 2-propanol, 1-butanol, 1-methoxy-2-propanol, ethylene glycol, diethylene glycol, and 1,3-propanediol.

Among these, propylene glycol monomethyl ether acetate is particularly preferable.

### (Other additives)

Various known additives can be appropriately mixed with the resin sheet and the resin composition for forming a resin sheet used in the present invention, within a range that does not impair the effects of the present invention. Examples of the additives include a cross-linking agent, a cross-linking accelerator, a plasticizer, a filler, wax, process oil, a metal oxide, an antiozonant, an antioxidant, a polymerization inhibitor, a coloring agent, and the like. One kind of these additives may be used singly, or two or more kinds thereof may be used in combination.

### (Polymerizable compound)

In order to accelerate the formation of a cross-linked structure, the resin sheet used in the present invention can be formed using the resin composition for forming a resin sheet containing a polymerizable compound. In a case where the resin composition contains a polymerizable compound, the formation of a cross-linked structure is accelerated, and the printing durability of the obtained cylindrical printing plate becomes excellent.

The aforementioned specific polymer having an ethylenically unsaturated group is not included in the polymerizable compound.

The polymerizable compound is preferably a compound having a molecular weight less than 3,000, and more preferably a compound having a molecular weight less than 1,000.

The polymerizable compound is preferably a radically polymerizable compound or an ethylenically unsaturated compound.

The polymerizable compound used in the present invention is preferably a polyfunctional ethylenically unsaturated compound. In a case where the above aspect is adopted, the printing durability of the obtained cylindrical printing plate is further improved.

As the polyfunctional ethylenically unsaturated compound, the compounds having 2 to 20 ethylenically unsaturated groups on the terminal are preferable. A group of these compounds is widely known in the field of the related art, and can be used in the present invention without particular limitation.

Examples of compounds from which the ethylenically unsaturated group in the polyfunctional ethylenically unsaturated compound is derived include unsaturated carboxylic acid (for example, acrylic acid, methacrylic acid, itaconic acid, crotonic acid, isocrotonic acid, or maleic acid) and esters or amides thereof. Among these, esters of unsaturated carboxylic acid and an aliphatic polyhydric alcohol compound and amides of unsaturated carboxylic acid and an aliphatic polyvalent amine compound are preferably used. Furthermore, a product of an addition reaction between an unsaturated carboxylic acid ester having a nucleophilic substituent such as a hydroxyl group or an amino group, amides, polyfunctional isocyanates, and epoxies, a product of a dehydrocondensation reaction with polyfunctional carboxylic acid, and the like are suitably used. In addition, a product of an addition reaction between an unsaturated carboxylic acid ester having an electrophilic substituent such as an isocyanate group or an epoxy group, amides, monofunctional or polyfunctional alcohols, and amines, and a product of a substitution reaction between an unsaturated carboxylic acid ester having a leaving substituent such as a halogen group or a tosyloxy group, amides, monofunctional or polyfunctional alcohols, and amines are suitable. As another example, instead of the aforementioned unsaturated carboxylic acid, it is possible to use a group of compounds substituted with a vinyl compound, an allyl compound, unsaturated sulfonic acid, styrene, or the like.

From the viewpoint of reactivity, the ethylenically unsaturated group contained in the polymerizable compound is preferably a residue of acrylate, methacrylate, a vinyl compound, or an allyl compound. Furthermore, from the viewpoint of printing durability, the polyfunctional ethylenically unsaturated compound more preferably has 3 or more ethylenically unsaturated groups.

Specific examples of monomers of esters of an aliphatic polyhydric alcohol compound and unsaturated carboxylic acid include acrylic acid esters such as ethylene glycol diacrylate, diethylene glycol diacrylate, triethylene glycol diacrylate, polyethylene glycol diacrylate, 1,3-butanediol diacrylate, tetramethylene glycol diacrylate, propylene glycol diacrylate, dipropylene glycol diacrylate, tripropylene glycol diacrylate, polypropylene glycol diacrylate, neopentyl glycol diacrylate, 1,6-hexanediol diacrylate, 1,4-cyclohexanediol diacrylate, tetraethylene glycol diacrylate, polytetramethylene glycol diacrylate, 1,8-octanediol diacrylate, 1,9-nonanediol diacrylate, 1,10-decanediol diacrylate, tricyclodecanedimethanol diacrylate, trimethylolpropane triacrylate, trimethylolpropane tri(acryloyloxypropyl)ether, ditrimethylolpropane tetraacrylate, trimethylolethane triacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate, and a polyester acrylate oligomer.

Specific examples of the aforementioned monomers include methacrylic acid esters such as tetramethylene glycol dimethacrylate, ethylene glycol dimethacrylate, diethylene glycol dimethacrylate, triethylene glycol dimethacrylate, polyethylene glycol dimethacrylate, propylene glycol dimethacrylate, dipropylene glycol dimethacrylate, tripropylene glycol dimethacrylate, polypropylene glycol dimethacrylate, neopentyl glycol dimethacrylate, trimethylolpropane trimethacrylate, trimethylolethane trimethacrylate, 1,3-butanediol dimethacrylate, 1,6-hexanediol dimethacrylate, 1,8-octanediol dimethacrylate, 1,9-nonanediol dimethacrylate, 1,10-decanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethyl methane, and bis[p-(methacryloxyethoxy)phenyl]dimethyl methane. Among these, trimethylolpropane trimethacrylate and polyethylene glycol dimethacrylate are particularly preferable.

Specific examples of the aforementioned monomers include itaconic acid esters such as ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

Specific examples of the aforementioned monomers include crotonic acid esters such as ethylene glycol dicrotonate, tetramethylene glycol dicrotonate, pentaerythritol dicrotonate, and sorbitol tetracrotonate.

Specific examples of the aforementioned monomers include isocrotoinc acid esters such as ethylene glycol diisocrotonate, pentaerythritol diisocrotonate, and sorbitol tetraisocrotonate.

Specific examples of the aforementioned monomers include maleic acid esters such as ethylene glycol dimaleate, triethylene glycol dimaleate, pentaerythritol dimaleate, and sorbitol tetramaleate.

As other esters, for example, the aliphatic alcohol-based esters described in JP1971-27926B (JP-S46-27926B), JP1976-47334B (JP-S51-47334B), and JP1982-196231A (JP-S57-196231A), the esters having an aromatic skeleton described in JP1984-5240A (JP-S59-5240A), JP1984-5241A (JP-S59-5241A), and JP1990-226149A (JP-H02-226149A), the amino group-containing esters described in JP1989-165613A (JP-H01-165613A), and the like are suitably used.

The aforementioned ester monomers can be used as a mixture.

Specific examples of monomers of an amide of an aliphatic polyvalent amine compound and unsaturated carboxylic acid include methylene bisacrylamide, methylene bismethacrylamide, 1,6-hexamethylenebis-acrylamide, 1,6-hexamethylenebismethacrylamide, diethylene triamine trisacrylamide, xylylene bisacrylamide, xylylene bismethacrylamide, and the like.

Examples other preferred amide-based monomers include the monomers having a cyclohexylene structure described in JP1979-21726B (JP-S54-21726B).

Furthermore, a urethane-based addition-polymerizable compound manufactured using an addition reaction of isocyanate and a hydroxyl group is also suitable. Specific examples of the compound include a vinyl urethane compound containing 2 or more polymerizable vinyl groups in one molecule that is obtained by adding a hydroxyl group-containing vinyl monomer represented by the following Formula (i) to a polyisocyanate compound having 2 or more isocyanate groups in one molecule that is described in JP1973-41708B (JP-S48-41708B), and the like.

CH₂=C(R)COOCH₂CH(R')OH (i)

(R and R' each represent H or CH₃.)

In addition, the urethane acrylates described in JP1976-37193A (JP-S51-37193A), JP1990-32293B (JP-H02-32293B), and JP1990-16765B (JP-H02-16765B) and the urethane compounds having an ethylene oxide-based skeleton described in JP1983-49860B (JP-S58-49860B), JP1981-17654B (JP-S56-17654B), JP1987-39417B (JP-S62-39417B), and JP1987-39418B (JP-S62-39418B) are also suitable.

By using the addition-polymerizable compounds having an amino structure in a molecule described in JP1988-277653A (JP-S63-277653A), JP1988-260909A (JP-S63-260909A), and JP1989-105238A (JP-H01-105238A), a curable composition can be obtained in a short time.

Examples of the aforementioned monomers also include polyfunctional acrylate or methacrylate such as the polyester acrylates described in JP1973-64183A (JP-S48-64183A), JP1974-43191B (JP-S49-43191B), and JP1977-30490B (JP-S52-30490B) and epoxy acrylates obtained by reacting an epoxy resin with (meth)acrylic acid, specific unsaturated compounds described in JP1971-43946B (JP-S46-43946B), JP1989-40337B (JP-H01-40337B), and JP1989-40336B (JP-H01-40336B), the vinyl phosphonate-based compound described in JP1990-25493A (JP-H02-25493A), and the like. In some cases, the structure containing a perfluoroalkyl group described in JP1986-22048A (JP-S61-22048A) is suitably used. Furthermore, it is possible to use those introduced as photocurable monomers and oligomers in The Journal of The Adhesion Society of Japan, vol. 20, No. 7, pp 300-308 (1984).

Examples of the vinyl compound include butanediol-1,4-divinyl ether, ethylene glycol divinyl ether, 1,2-propanediol divinyl ether, 1,3-propanediol divinyl ether, 1,3-butanediol divinyl ether, 1,4-butanediol divinyl ether, neopentyl glycol divinyl ether, trimethylolpropane trivinyl ether, trimethylolethane trivinyl ether, hexanediol divinyl ether, tetraethylene glycol divinyl ether, pentaerythritol divinyl ether, pentaerythritol trivinyl ether, pentaerythritol tetravinyl ether, sorbitol tetravinyl ether, sorbitol pentavinyl ether, ethylene glycol diethylene vinyl ether, ethylene glycol dipropylene vinyl ether, trimethylolpropane triethylene vinyl ether, trimethylolpropane diethylene vinyl ether, pentaerythritol diethylene vinyl ether, pentaerythritol triethylene vinyl ether, pentaerythritol tetraethylene vinyl ether, 1,1,1-tris[4-(2-vinyloxyethoxy)phenyl]ethane, bisphenol A divinyloxyethyl ether, divinyl adipate, and the like.

In the resin sheet used in the present invention and the resin composition used for forming the resin sheet, only one kind of polymerizable compound may be used, or two or more kinds thereof may be used in combination.

The content of the polymerizable compound in the resin sheet used in the present invention is, with respect to the total mass of the solid content of the resin composition, preferably 0.1% to 30% by mass, more preferably 0.5% to 20% by mass, and even more preferably 1% to 10% by mass.

The content of the polymerizable compound in the resin composition for forming a resin sheet used in the present invention is, with respect to the total mass of the solid content of the resin composition, preferably 0.1% to 30% by mass, more preferably 0.5% to 20% by mass, and even more preferably 1% to 10% by mass. In a case where the content of the polymerizable compound is within the above range, the rising properties of engraving scum that occurs at the time of laser engraving are further improved, and the printing durability of the obtained cylindrical printing plate is further improved.

### (Amount of each component mixed in)

The total content of the specific polymer in the resin sheet is preferably 5% to 90% by mass with respect to the total mass of the solid content of the resin sheet used in the present invention. The content of the polymerization initiator in the resin sheet is preferably 0.01% to 30% by mass with respect to the total mass of the solid content of the resin sheet used in the present invention. The content of the photothermal conversion agent in the resin sheet is preferably within a range of 0.01% to 30% by mass with respect to the total mass of the solid content of the resin sheet used in the present invention. The content of the polymerizable compound is preferably 0% to 30% by mass with respect to the total mass of the solid content of the resin sheet used in the present invention.

The total content of the specific polymer in the resin composition for forming a resin sheet is preferably 5% to 90% by mass with respect to the total mass of the solid content of the resin composition for forming a resin sheet used in the present invention. The content of the polymerization initiator in the resin composition is preferably 0.01% to 30% by mass with respect to the total mass of the solid content of the resin composition for forming a resin sheet used in the present invention. The content of the photothermal conversion agent in the resin composition is preferably within a range of 0.01% to 30% by mass with respect to the total mass of the solid content of the resin composition for forming a resin sheet used in the present invention. The content of the polymerizable compound in the resin composition is preferably 0% to 30% by mass with respect to the total mass of the solid content of the resin composition for forming a resin sheet used in the present invention.

### (Method for curing resin sheet)

Hereinafter, a method for curing the resin sheet will be described.

The resin sheet used in the present invention is preferably a sheet cured by the action of heat and/or light.

In a case where the resin sheet used in the present invention contains a photopolymerization initiator, the resin sheet can be cured by being irradiated with light.

It is preferable that the entire surface of the resin sheet is irradiated with light.

Examples of light include visible light, ultraviolet light, and electron beams, and among these, ultraviolet light is most preferable. In a case where the support side of the resin sheet is regarded as a rear surface, only a front surface may be irradiated with light. However, in a case where the support is a transparent film that transmits light, it is preferable to irradiate the rear surface as well. In a case where the resin sheet includes a protective film, the front surface may be irradiated with light in the presence of the protective film or may be irradiated with light after the protective film is peeled off. In a case where there is a concern that the cross-linking reaction will be hindered in the presence of oxygen, the resin sheet may be irradiated with light after being covered with a vinyl chloride sheet and subjected to vacuuming.

In a case where the resin sheet contains a thermal polymerization initiator (the aforementioned photopolymerization initiator can be a thermal polymerization initiator), the resin sheet can be cured by heating (thermal cross-linking step). Examples of means for heating for performing thermal cross-linking include a method of heating the resin sheet in a hot air oven or an infrared oven for a certain period of time and a method of bringing the resin sheet into contact with a heated roll for a certain period of time.

As the method for curing the resin sheet, thermal cross-linking is preferable because this method enables the resin sheet to be uniformly cured (cross-linked) from the surface to the inside.

By the cross-linking of the resin sheet, first, an advantage in that a relief formed after laser engraving becomes sharp, and second, an advantage in that pressure sensitive adhesiveness of the engraving scum that occurs at the time of laser engraving is suppressed are obtained.

If necessary, the method for producing the flexo printing plate may further include, after the engraving step, the following rinsing step, drying step, and/or post-cross-linking step.
Rinsing step: a step of rinsing the engraved surface of the engraved relief layer with water or a liquid containing water as a main component
Drying step: a step of drying the engraved relief layer
Post-cross-linking step: a step of further cross-linking the relief layer by applying energy to the engraved relief layer

After the engraving step is performed, engraving scum is attached to the engraved surface. Therefore, a rinsing step of washing off the engraving scum by rinsing the engraved surface with water or a liquid containing water as a main component may be added. Examples of means for rinsing include a method of performing rinsing with tap water; a method of spraying water at a high pressure; a method of brushing the engraving surface mainly in the presence of water by using a batch-type or transport-type brush-like rinsing machine known as a developing machine for a photosensitive resin letterpress; and the like. In a case where sliminess of the engraving scum is not removed, a rinsing solution to which soap or a surfactant is added may be used.

In a case where the rinsing step of rinsing the engraved surface is performed, it is preferable to add a drying step of drying the engraved recording layer so as to volatilize the rinsing solution.

Furthermore, if necessary, a post-cross-linking step of further cross-linking the engraved recording layer may be added. By performing the post-cross-linking step which is an additional cross-linking step, it is possible to toughen the relief formed by engraving.

The pH of the rinsing solution used in the rinsing step is preferably equal to or greater than 9, more preferably equal to or greater than 10, and even more preferably equal to or greater than 11. Furthermore, the pH of the rinsing solution is preferably equal to or less than 14, more preferably equal to or less than 13.5, and even more preferably equal to or less than 13.1. If the pH is within the above range, it is easy to handle the rinsing solution. In order to make the pH of the rinsing solution fall into the above range, the pH should be appropriately adjusted using an acid and/or a base, and the acid and base used are not particularly limited.

It is preferable that the rinsing solution contains water as a main component. Furthermore, the rinsing solution may contain, as a solvent other than water, a water-miscible solvent such as alcohols, acetone, or tetrahydrofuran.

It is preferable that the rinsing solution contains a surfactant. As the surfactant, from the viewpoint of engraving scum removability and reducing the influence on the flexo printing plate, a betaine compound (amphoteric surfactant) such as a carboxybetaine compound, a sulfobetaine compound, a phosphobetaine compound, an amine oxide compound, or a phosphine oxide compound is preferably exemplified. In the present invention, the N=O structure of an amine oxide compound and the P=O structure of a phosphine oxide compound are regarded as N⁺-O⁻ and P⁺-O⁻ respectively.

Examples of the surfactant also include known anionic surfactants, cationic surfactants, amphoteric surfactants, nonionic surfactants, and the like. Furthermore, nonionic surfactants based on fluorine and silicone can also be used.

One kind of surfactant may be used singly, or two or more kinds thereof may be used concurrently.

The amount of the surfactant used does not need to be particularly limited. However, it is preferably 0.01% by mass to 20% by mass, and more preferably 0.05% by mass to 10% by mass, with respect to the total mass of the rinsing solution.

From the viewpoint of satisfying various printing suitabilities such as abrasion resistance and ink transferability, the thickness of the relief layer (cured layer) included in the prepared flexo printing plate is preferably equal to or greater than 0.05 mm and equal to or less than 10 mm, more preferably equal to or greater than 0.05 mm and equal to or less than 7 mm, and particularly preferably equal to or greater than 0.05 mm and equal to or less than 3 mm.

The Shore A hardness of the relief layer included in the prepared flexo printing plate is preferably equal to or greater than 50° and equal to or less than 90°. If the Shore A hardness of the relief layer is equal to or greater than 50°, printing can be normally performed without causing the minute halftone dots formed by engraving to be collapsed and crushed due to the strong printing pressure of the letterpress printing machine. Furthermore, if the Shore A hardness of the relief layer is equal to or less than 90°, it is possible to prevent the occurrence of printing blurring in a solid portion even if flexo printing is performed at a kiss-touch printing pressure.

Herein, the Shore A hardness in the present specification is a value measured by a durometer (spring-type rubber hardness tester) which pushes a stylus (referred to as an indenter point or an indenter) into the surface of the measurement target so as to cause deformation, measures the deformation amount (indentation depth), and digitizes the deformation amount.

### [Flexo printing apparatus]

Next, the constitution of a flexo printing apparatus (hereinafter, simply referred to as a "printing apparatus" as well) using the flexo printing plate according to the present invention will be specifically described. Except for using the flexo printing plate described above, the flexo printing apparatus basically has the same constitution as the flexo printing apparatus of the related art.

Fig. 8 is a view conceptually showing main portions of the flexo printing apparatus using the flexo printing plate according to the present invention.

As shown in Fig. 8, a flexo printing apparatus 30 has a flexo printing plate 1 described above, a plate cylinder 31, an impression cylinder 32, an anilox roller 33, a doctor chamber 34, and a doctor blade 36.

The plate cylinder 31 is a cylindrical drum and mounted on the peripheral surface of the flexo printing plate 1. The plate cylinder is for bringing the flexo printing plate 1 into contact with the printing target Z while rotating.

The impression cylinder 32 is a roller constituting a transport portion (not shown in the drawing) which transports the printing target Z along a predetermined transport path. The impression cylinder 32 is disposed such that the peripheral surface thereof faces the peripheral surface of the plate cylinder 31, and brings the printing target Z into contact with the flexo printing plate 1.

The plate cylinder 31 is disposed such that the rotation direction thereof becomes identical to the transport direction of the printing target Z.

The anilox roller 33, the doctor chamber 34, and the doctor blade 36 are for supplying ink to the flexo printing plate 1. The doctor chamber 34 is provided so as to come into close contact with the surface of the anilox roller 33 and holds ink on the inside thereof. By a circulation tank (not shown in the drawing), ink is supplied to the doctor chamber 34. The ink in the doctor chamber 34 is supplied to the surface of the anilox roller 33. The doctor blade 36 adjusts the amount of ink by scraping off unnecessary ink adhering to the surface of the anilox roller 33. The anilox roller 33 rotates in synchronization with the plate cylinder 31 in a state of contacting the peripheral surface of the plate cylinder 31, such that the printing plate 1 is coated (supplied) with ink.

While transporting the printing target Z in a predetermined transport path, the flexo printing apparatus 30 constituted as above rotates the flexo printing plate 1 placed on the plate cylinder 31 and transfers the ink to the printing target Z, thereby performing printing. That is, the rotation direction of the plate cylinder onto which the flexo printing plate is mounted becomes the printing direction.

The type of the printing target used in the flexo printing apparatus using the flexo printing plate of the present invention is not particularly limited, and various known printing targets used in general flexo printing apparatuses, such as paper, films, and cardboards, can be used.

Furthermore, the type of the ink used in the flexo printing apparatus using the flexo printing plate of the present invention is not particularly limited, and various known inks used in general flexo printing apparatuses, such as an aqueous ink, a UV ink, an oil ink, and an EB ink, can be used.

### Examples

Hereinafter, the present invention will be more specifically described based on examples, but the present invention is not limited thereto.

In the examples, unless otherwise specified, a number-average molecular weight (Mn) and a weight-average molecular weight (Mw) of a polymer represent values measured by a GPC method.

### <Example 1>

### <Preparation of flexo printing plate>

By using a laser engraving machine (Premium Setter 1300S manufactured by Hell Gravure Systems), as a flexo printing plate precursor, a DLE-type flexo plate FLENEX FD-H (manufactured by FUJIFILM Corporation) was engraved at a resolution of 2,540 dpi, a laser power (Depth power) of 100%, and a dot shape profile: slope of 60°, such that the following shape was obtained. Then, a washer (2% aqueous solution of JOY W Sterilization manufactured by Procter & Gamble Company) was applied onto the plate, the plate was rubbed with a pig hair brush and rinsed with running water such that the engraving scum was removed.

The printing plate having undergone engraving was caused to have such a shape that a 135 mm × 210 mm image portion is positioned at the center of the printing plate as shown in Fig. 1A. A non-image portion adjacent to this image portion continued 2 mm or further in a direction away from the edge of the image portion.

The entirety of the image portion was constituted with halftone dots having a halftone dot rate of 10%.

Furthermore, the printing plate had a constitution in which a lowered region was on the distal end side of the image portion in the printing direction. The lowering amount Δ at the edge on the distal end side of the image portion, that is, the maximum value of the lowering amount Δ was set to be 40 µm, and the width La of the lowered region was set to be 1 mm.

### <Comparative Example 1>

A flexo printing plate was prepared in the same manner as in Example 1, except that a lowered region was not formed.

### [Evaluation]

Printing was performed using the obtained flexo printing plates, and the density was measured so as to perform evaluation regarding whether or not bouncing occurred.

### (Printing step)

MIRAFLEX AM (manufactured by Windmoller & Holscher Corporation) was used as a printer, and a sleeve manufactured by ROSSINI was used as a plate cylinder.

The obtained printing plate was bonded to the plate cylinder through a cushion tape (manufactured by Lohmann Technologies Ltd) and installed in the printer. Then, a kiss touch (printing pressure at which inking begins within the entire surface of an image) was set to be 0 (standard printing pressure), and under the condition in which the indentation amount became 40 µm from the kiss touch, printing was performed at a printing rate of 150 m/min.

As a printing target, an OPP film (manufactured by Abe Paper Industries) having a thickness of 50 µm was used. As ink, HYDRIC FCF (manufactured by Dainichiseika Color & Chemicals Mfg. Co., Ltd.) as an aqueous flexo ink was used.

### (Density measurement)

For the printed image, the density on one line in the printing direction was measured.

For measuring the density, the printed material was read using a scanner, and the read image data was converted into density. In this way, the concentration was measured.

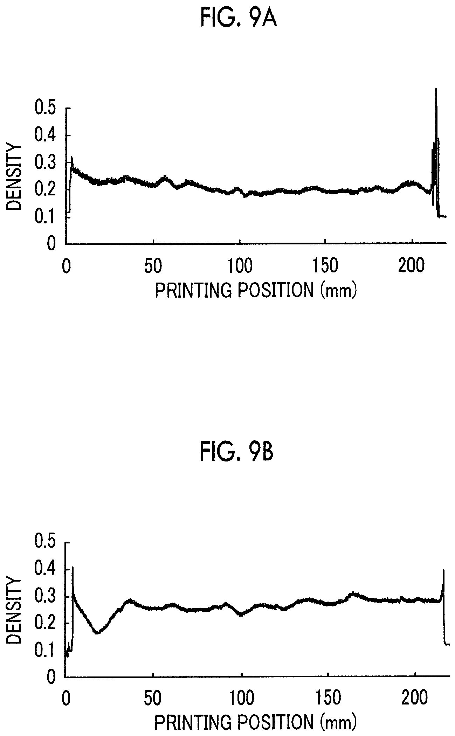

Fig. 9A is a graph showing the measured density of Example 1, and Fig. 9B is a graph showing the density of Comparative Example 1.

From the result shown in Fig. 9B, it is understood that in Comparative Example 1 not being provided with a lowered region, the density in the distal end portion of the image portion is higher than a desired density (halftone dot rate), and the density is reduced in a position 17 mm distant from the edge on the distal end side. That is, it is understood that due to the impact force exerted in a case where the distal end of the image portion contacts the printing target, bouncing occurs, and hence unevenness occurs in the printed image.

In contrast, from the result shown in Fig. 9A, it is understood that in Example 1 of the present invention having a constitution, in which a region that extends 0.5 mm to 5 mm from the distal end side of the image portion in the printing direction is a lowered region having a height shorter than a height of the image portion other than the aforementioned region and the lowered region is gradually lowered toward the non-image portion in the printing direction, the variation of the density is small across the entirety of the image portion, and the unevenness is also small.

The above results clarify the effects of the present invention.

### Explanation of References

1, 100, 210, 220: flexo printing plate
2, 102: non-image portion
3, 103, 200, 202, 204: image portion
3a: edge on distal end side
4: lowered region
30: flexo printing apparatus
31, 100: plate cylinder
32, 104: impression cylinder
33: anilox roller
34: doctor chamber
36: doctor blade
50: original image data
60: calender roll
62a to 62d: first to fourth rolls
70: kneaded material
71: resin sheet
222: obi portion
z: printing target

## Claims

1. A flexo printing plate comprising:
an image portion; and
a non-image portion,
wherein a region that extends 0.5 mm to 5 mm from a distal end side of the image portion in a printing direction is a lowered region having a height shorter than a height of said image portion other than the region, and
said height of said lowered region is gradually lowered toward said non-image portion in said printing direction.

2. The flexo printing plate according to claim 1,
wherein a maximum value of a lowering amount in said lowered region is 20 µm to 120 µm.

3. The flexo printing plate according to claim 1 or 2,
wherein said lowered region is formed in said image portion adjacent to said non-image portion that continues 2 mm or further in a direction away from an edge of said image portion.

4. A method for producing a flexo printing plate having an image portion and a non-image portion, comprising:
an image data obtainment step of obtaining original image data of an image to be printed;
a first engraving image generation step of generating first engraving shape image data from said obtained original image data;
a lowering mask generation step of generating lowering mask data for lowering a height of a part of said image portion by detecting a boundary between said image portion and said non-image portion from said original image data and based on said position of said boundary; and
a second engraving image generation step of generating second engraving shape image data in which a region that extends 0.5 mm to 5 mm from a distal end side of said image portion in a printing direction is lowered, by applying said lowering mask data to said first engraving shape image data.

5. The method for producing a flexo printing plate according to claim 4,
wherein a maximum value of a lowering amount determined by said lowering mask data is 20 µm to 120 µm.

6. The method for producing a flexo printing plate according to claim 4 or 5,
wherein in said lowering mask data generation step, said lowering mask data is generated based on a position of a boundary of said image portion adjacent to said non-image portion that continues 2 mm or further in a direction away from an edge of said image portion.

7. The method for producing a flexo printing plate according to any one of claims 4 to 6,
wherein in said first engraving image generation step, said original image data is converted into halftone dot image data, and
said first engraving shape image data is generated based on said halftone dot image data.

8. The method for producing a flexo printing plate according to any one of claims 4 to 7, further comprising;
an engraving step of laser-engraving a flexo printing plate precursor based on said second engraving shape image data.
